# EUROPEAN PATENT APPLICATION

(11) **EP 4 730 932 A1**
(43) Date of publication of application: **22.04.2026**
(21) Application number: 24910721.0
(22) Date of filing: 11.12.2024
(51) Int. Cl.: H05K 5/06

(54) **METHOD FOR SEALING STRUCTURAL MEMBERS AND ELECTRONIC DEVICE**

(30) Priority: 26.12.2023 CN 202311818637
(71) Applicant: Huawei Technologies Co., Ltd., Shenzhen, Guangdong 518129 (CN)
(72) Inventor: HAN, Suqi, Shenzhen, Guangdong 518129 (CN); XIANG, Lei, Shenzhen, Guangdong 518129 (CN); ZHANG, Youliang, Shenzhen, Guangdong 518129 (CN)
(74) Representative: Isarpatent
(86) International application number: PCT/CN2024/138429
(87) International publication number: WO 2025/139790

(57) **Abstract**

Embodiments of this application provide a mechanical part sealing method and an electronic device, and belong to the field of sealing technologies. The mechanical part sealing method includes: providing a mechanical part, where the mechanical part includes a first mechanical part and a second mechanical part, there is a sealing channel between the first mechanical part and the second mechanical part, and the sealing channel includes a first opening and a second opening; placing the mechanical part in a first environment, and making the second opening be in a sealed state; injecting sealant with a preset volume into the sealing channel from the first opening, where the sealant automatically flows toward the second opening in the first environment; and placing the mechanical part in a second environment after a first preset time, where pressure of the second environment is greater than pressure of the first environment, for sealing and filling the sealing channel with the sealant under a pressure difference between the second environment and the first environment. In the mechanical part sealing method, an amount of the sealant is controllable, and there is no problem of sealant overflow or sealant leakage in the sealing channel.

## Description

This application claims priority to Chinese Patent Application No. 202311818637.7, filed with the China National Intellectual Property Administration on December 26, 2023 and entitled "MECHANICAL PART SEALING METHOD AND ELECTRONIC DEVICE", which is incorporated herein by reference in its entirety.

### TECHNICAL FIELD

This application relates to the field of sealing technologies, and in particular, to a mechanical part sealing method and an electronic device.

### BACKGROUND

With rapid development of power electronics technologies, electronic products have increasingly types and functions, and people have higher requirements on waterproof performance of consumer electronic products, such as mobile phones, tablets, notebook computers, and wearable devices. The electronic product includes a plurality of components. When the electronic product is assembled, some through holes for connection are usually disposed on the components of the electronic product. A connector is disposed in the through hole to connect two components, resulting in some gaps between the connector and an inner wall of the through hole and between the adjacent components. To meet a waterproof specification of the consumer electronic product, the gaps of the electronic product need to be sealed.

Generally, a manner of directly injecting a sealant into the gap of the electronic product may be used, so that the gap of the electronic product can be sealed based on fluidity of the sealant. However, when a viscosity of the sealant is low, a problem of sealant overflow or sealant leakage easily occurs; or when a viscosity of the sealant is high, positions of an irregular gap and a micro-gap in the gap cannot be effectively filled. To resolve the foregoing problems, negative pressure is drawn on an appearance surface of the gap, so that the gap is filled with the sealant with the high viscosity under action of the negative pressure.

However, although applying the negative pressure to the appearance surface of the gap can make the glue with the high viscosity enter the gap, the problem of sealant overflow or sealant leakage of the product cannot be resolved.

### SUMMARY

This application provides a mechanical part sealing method and an electronic device. The mechanical part sealing method can effectively resolve a problem of glue overflow or glue leakage of a product.

A first aspect of embodiments of this application provides a mechanical part sealing method. The sealing method includes: providing a mechanical part, where the mechanical part includes a first mechanical part and a second mechanical part, there is a sealing channel between the first mechanical part and the second mechanical part, and the sealing channel includes a first opening and a second opening; placing the mechanical part in a first environment, and making the second opening be in a sealed state; injecting sealant with a preset volume into the sealing channel from the first opening, where the sealant automatically flows toward the second opening in the first environment; and placing the mechanical part in a second environment after a first preset time, where pressure of the second environment is greater than pressure of the first environment, for sealing and filling the sealing channel with the sealant under a pressure difference between the second environment and the first environment.

According to the mechanical part sealing method provided in this embodiment of this application, the second opening of the sealing channel is sealed, so that a problem of sealant overflow or sealant leakage after the sealing channel is sealed can be prevented, and an amount of the sealant can be controlled. The mechanical part is first placed in the first environment, and the sealant with the preset volume is injected into the sealing channel from the first opening, so that the amount of the sealant can be controlled, and the sealant can be injected into the sealing channel. The mechanical part is placed in the second environment after the first preset time, so that a part or all of the sealant can be injected into the sealing channel when the sealant is in the first environment. The pressure of the second environment is set to be greater than the pressure of the first environment, so that a remaining part of the sealant or all the sealant entering the sealing channel can seal and fill the sealing channel based on the pressure difference between the second environment and the first environment, to ensure that positions of an irregular gap and a micro-gap in the sealing channel can be effectively filled. In addition, the sealant fills the sealing channel under positive pressure extrusion. This can reduce a risk of bubbles in the sealant compared with filling by drawing negative pressure.

In a possible implementation, before or after placing the mechanical part in the first environment, the method further includes: disposing, at the second opening, a sealing structure used to seal the second opening, for the second opening to be in the sealed state.

The sealing structure used to seal the second opening is disposed at the second opening, so that the second opening is in the sealed state. This can ensure that there is no problem of sealant leakage or sealant overflow at the second opening, and can ensure that an outer side of the second opening is flat. In this way, when the second opening faces an appearance surface of the mechanical part, neatness and aesthetics of the appearance surface can be ensured.

In a possible implementation, after placing the mechanical part in the second environment, the method further includes: removing the sealing structure from the second opening after a second preset time.

After the mechanical part is placed in the second environment, the sealing mechanism is removed from the second opening after the second preset time, so that there is no redundant component on the mechanical part, and a structure of the mechanical part is simplified. In addition, when the second opening faces the appearance surface of the mechanical part, aesthetics of the mechanical part can be improved.

In a possible implementation, the sealing structure includes a peelable sealant.

The sealing structure is set to include the peelable sealant, and the sealing structure can be easily removed after the sealing channel is sealed. This can reduce difficulty in removing the sealing structure, and further reduce sealing costs of the mechanical part.

In a possible implementation, the sealing structure includes a fixture, and a partial structure of the fixture is disposed at the second opening, and is connected to the second opening in a sealing manner.

The sealing structure is set to include the fixture, so that the second opening can be sealed through a specific operation provided that the mechanical part is placed on the fixture. This can simplify a procedure of sealing the second opening of the sealing channel, thereby improving sealing efficiency of the mechanical part.

In a possible implementation, providing the mechanical part includes: forming an appearance surface on at least one of the first mechanical part and the second mechanical part; and extending the second opening to the appearance surface.

The appearance surface is formed on at least one of the first mechanical part and the second mechanical part, and the second opening extends to the appearance surface, to ensure, when the sealing channel is sealed, that there is no problem of sealant leakage or sealant overflow on the appearance surface of the mechanical part and that the appearance surface is flat and beautiful.

In a possible implementation, the first environment is a negative pressure environment.

When the first environment is set to a negative pressure environment, the second environment may be set to a standard atmospheric pressure environment or an air environment. In this way, a pressure difference can be formed between the second environment and the first environment, to ensure that the positions of the irregular gap and the micro-gap in the sealing channel can be effectively filled. In addition, the sealant fills the sealing channel under positive pressure extrusion. This can reduce a risk of bubbles in the sealant compared with filling by drawing negative pressure. In addition, only a negative pressure environment needs to be provided, and pressure relief needs to be performed on the first environment after the first preset time. The operation is simple, and a step of sealing the mechanical part can be simplified. In addition, the negative pressure environment is easy to provide, and the air environment is also easy to provide. Therefore, sealing costs of the mechanical part can be reduced.

In a possible implementation, the first environment is a standard atmospheric pressure environment or an air environment.

When the first environment is set to a standard atmospheric pressure environment or an air environment, the second environment may be set to an environment whose atmospheric pressure is greater than that of the standard atmospheric pressure environment or the air environment. In this way, a pressure difference can be formed between the second environment and the first environment, to ensure that the positions of the irregular gap and the micro-gap in the sealing channel can be effectively filled. In addition, the sealant fills the sealing channel under positive pressure extrusion. This can reduce a risk of bubbles in the sealant 13 compared with filling by drawing negative pressure. In addition, the standard atmospheric pressure environment or the air environment is easy to obtain, and the second environment can be obtained only by pressurizing the first environment. The operation is simple, and sealing costs of the mechanical part can be reduced.

In a possible implementation, when the first environment is a negative pressure environment, before injecting the sealant with the preset volume into the sealing channel from the first opening, the method further includes: obtaining a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part; and adjusting a negative pressure value of the first environment based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

Before the sealant with the preset volume is injected into the sealing channel from the first opening, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the negative pressure value of the first environment is adjusted based on one or more of the foregoing parameters. This can improve accuracy of the negative pressure value of the first environment, thereby improving sealing efficiency.

In a possible implementation, when the first environment is a standard atmospheric pressure environment or an air environment, after injecting the sealant with the preset volume into the sealing channel from the first opening, the method further includes: obtaining a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part; and adjusting an atmospheric pressure value of the second environment based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

After the sealant with the preset volume is injected into the sealing channel from the first opening, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the atmospheric pressure value of the second environment is adjusted based on one or more of the foregoing parameters. This can improve accuracy of the atmospheric pressure value of the second environment, thereby improving sealing efficiency.

In a possible implementation, before injecting the sealant with the preset volume into the sealing channel from the first opening, the method further includes: obtaining the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and determining the first preset time based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

Before the sealant with the preset volume is injected into the sealing channel from the first opening, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the first preset time is determined based on one or more of the foregoing parameters. This can improve accuracy of a sealant injection time of the mechanical part in the first environment, thereby ensuring sealing performance of the sealing channel and improving sealing efficiency.

In a possible implementation, before injecting the sealant with the preset volume into the sealing channel from the first opening, the method further includes: obtaining the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and determining the preset volume of the sealant based on one or more of the volume of the sealing channel, the viscosity of the sealant, the curing manner of the sealant, the bubble discharge performance of the sealant under positive pressure extrusion, and the material of the mechanical part.

Before the sealant with the preset volume is injected into the sealing channel from the first opening, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the preset volume of the sealant is determined based on one or more of the foregoing parameters. This can improve accuracy of the amount of the sealant in the sealing channel, can avoid sealant overflow, and can also avoid poor sealing effect caused by insufficiency of a sealing member, thereby ensuring sealing performance of the sealing channel and improving sealing efficiency.

In a possible implementation, a size of the first opening is greater than a size of the second opening.

The size of the first opening is set to be greater than that of the second opening, so that when the sealant is injected into the sealing channel from the first opening, the sealant can be conveniently injected into the sealing channel from the first opening. This improves sealing efficiency of the mechanical part. Because the second opening is away from the appearance surface of the mechanical part, setting the size of the second opening to be large does not affect the appearance surface of the mechanical part.

In a possible implementation, one of the first mechanical part and the second mechanical part is a display, and the other of the first mechanical part and the second mechanical part is a middle frame of an electronic device. The sealing channel is a gap between the display and the middle frame.

One of the first mechanical part and the second mechanical part is disposed as the display, and the other of the first mechanical part and the second mechanical part is disposed as the middle frame of the electronic device. In this way, sealing can be performed between the middle frame and the display, to improve waterproof performance of the electronic device in which the mechanical part is used.

In a possible implementation, one of the first mechanical part and the second mechanical part is a flexible circuit board, and the other of the first mechanical part and the second mechanical part is a middle frame or an adapter of an electronic device. The middle frame or the adapter of the electronic device is provided with a through hole for the flexible circuit board to pass through. The sealing channel is a gap between the flexible circuit board and an inner wall of the through hole. Alternatively, the sealing channel is a gap between the flexible circuit board and the middle frame. Alternatively, the sealing channel is a gap between the middle frame or the adapter.

One of the first mechanical part and the second mechanical part is disposed as the flexible circuit board, and the other of the first mechanical part and the second mechanical part is disposed as the middle frame or the adapter. In this way, sealing can be performed on the through hole on the middle frame or the adapter and the flexible circuit board, to improve waterproof performance of the electronic device in which the mechanical part is used.

In a possible implementation, one of the first mechanical part and the second mechanical part is a screw or a bolt, and the other of the first mechanical part and the second mechanical part is an adapter. The adapter is provided with a threaded hole for the screw or the bolt to pass through. The sealing channel is a gap between the screw or the bolt and an inner wall of the threaded hole.

One of the first mechanical part and the second mechanical part is disposed as the screw or the bolt, and the other of the first mechanical part and the second mechanical part is disposed as the adapter. In this way, sealing can be performed on the threaded hole on the adapter and the bolt or the screw, to improve waterproof performance of the electronic device in which the mechanical part is used.

A second aspect of embodiments of this application provides an electronic device, including a mechanical part. The mechanical part includes a first mechanical part and a second mechanical part, and there is a sealing channel between the first mechanical part and the second mechanical part. A sealant is disposed in the sealing channel, and the sealant seals the sealing channel by using any one of the mechanical part sealing methods.

The sealant in the sealing channel of the mechanical part of the electronic device seals the sealing channel by using the foregoing mechanical part sealing method. This can improve sealing performance of the mechanical part, thereby improving waterproof performance of the electronic device. In addition, appearance aesthetics of the electronic device can be further ensured.

In a possible implementation, one of the first mechanical part and the second mechanical part is a display of the electronic device, and the other of the first mechanical part and the second mechanical part is a middle frame of the electronic device. The sealing channel is a gap between the display and the middle frame.

The first mechanical part and the second mechanical part are disposed as the display and the middle frame respectively. This can improve sealing performance between the display and the middle frame, thereby improving waterproof performance of the electronic device.

In a possible implementation, each of the display and the middle frame has an appearance surface. An opening at one end of the sealing channel extends to between the appearance surface of the display and the appearance surface of the middle frame, and an opening at the other end of the sealing channel faces an interior of the electronic device.

Each of the display and the middle frame is provided with the appearance surface, the opening at the one end of the sealing channel extends to between the appearance surface of the display and the appearance surface of the middle frame, and the opening at the other end of the sealing channel faces the interior of the electronic device. This can seal one end that is of the sealing channel and that faces the appearance surface of the display and the appearance surface of the middle frame while sealing the sealing channel, thereby ensuring aesthetics of an appearance surface of the electronic device.

In a possible implementation, one of the first mechanical part and the second mechanical part is a flexible circuit board of the electronic device, and the other of the first mechanical part and the second mechanical part is a middle frame or an adapter of the electronic device. The middle frame or the adapter of the electronic device is provided with a through hole for the flexible circuit board to pass through. The sealing channel is a gap between the flexible circuit board and an inner wall of the through hole, or the sealing channel is a gap between the middle frame or the adapter.

One of the first mechanical part and the second mechanical part is disposed as the flexible circuit board, and the other of the first mechanical part and the second mechanical part is disposed as the middle frame or the adapter. In this way, sealing can be performed on the through hole on the middle frame or the adapter and the flexible circuit board, to improve waterproof performance of the electronic device.

In a possible implementation, one of the first mechanical part and the second mechanical part is a screw or a bolt of the electronic device, and the other of the first mechanical part and the second mechanical part is an adapter of the electronic device. The adapter is provided with a threaded hole for the screw or the bolt to pass through. The sealing channel is a gap between the screw or the bolt and an inner wall of the threaded hole.

One of the first mechanical part and the second mechanical part is disposed as the screw or the bolt, and the other of the first mechanical part and the second mechanical part is disposed as the adapter. In this way, sealing can be performed on the threaded hole on the adapter and the bolt or the screw, to improve waterproof performance of the electronic device.

In a possible implementation, the sealing channel has a sealing end and a sealant injection end. A size of the sealant injection end is greater than a size of the sealing end, and the sealant injection end is located inside the electronic device.

The size of the sealant injection end is set to be greater than that of the sealing end, so that when the sealant is injected into the sealing channel from the sealant injection end, the sealant can be conveniently injected into the sealing channel from the sealant injection end. This improves sealing efficiency of the mechanical part. Because the sealant injection end is disposed inside the electronic device, setting the size of the sealant injection end to be large does not affect the appearance surface of the mechanical part. In addition, when the sealing end faces the appearance surface of the mechanical part, the aesthetics of the appearance surface of the electronic device can be improved.

### BRIEF DESCRIPTION OF DRAWINGS

FIG. 1 is a diagram of a structure of a mechanical part;
FIG. 2 is a diagram of a structure of a mechanical part;
FIG. 3 is a diagram of a structure of a mechanical part;
FIG. 4 is a schematic flowchart of a mechanical part sealing method according to an embodiment of this application;
FIG. 5 is a diagram of a structure of a mechanical part according to an embodiment of this application;
FIG. 6 is a diagram of a structure of a mechanical part according to an embodiment of this application;
FIG. 7 is a diagram of a structure in which a second opening of a sealing channel of a mechanical part is sealed according to an embodiment of this application;
FIG. 8 is a diagram of a structure in which a second opening of a sealing channel of a mechanical part is sealed according to an embodiment of this application;
FIG. 9 is a schematic flowchart of obtaining a preset volume of a sealant in a mechanical part sealing method according to an embodiment of this application;
FIG. 10 is a diagram of a structure during injecting a sealant into a first opening of a sealing channel of a mechanical part according to an embodiment of this application;
FIG. 11 is a schematic flowchart of obtaining a first preset time in a mechanical part sealing method according to an embodiment of this application;
FIG. 12 is a diagram of a structure in which a mechanical part is placed in a second environment according to an embodiment of this application;
FIG. 13 is a schematic flowchart of a mechanical part sealing method according to an embodiment of this application;
FIG. 14 is a diagram of a structure in which a sealing structure at a second opening of a sealing channel of a mechanical part is removed according to an embodiment of this application;
FIG. 15 is a schematic flowchart of obtaining a negative pressure value of a first environment in a mechanical part sealing method according to an embodiment of this application;
FIG. 16 is a schematic flowchart of obtaining an atmospheric pressure value of a second environment in a mechanical part sealing method according to an embodiment of this application; and
FIG. 17 is a diagram of a disassembled structure of an electronic device according to an embodiment of this application.

### Descriptions of reference numerals:

100: mechanical part; 10: first mechanical part; 11: second mechanical part;
12: sealing channel; 121: first opening; 122: second opening;
13: sealant; 14: sealing structure; 141: sealing part;
142: fastening part; 15: appearance surface; 20: first component;
30: second component; 40: gap; 41: sealant injection end;
42: non-sealant-injection end; 44: appearance surface; 50: sealant;
200: electronic device; 210: display; 220: middle frame;
230: flexible circuit board; 240: housing; and 250: battery.

### DESCRIPTION OF EMBODIMENTS

Terms used in implementations of this application are only used to explain specific embodiments of this application, but are not intended to limit this application.

Unless otherwise required in the context, throughout this specification and claims, the term "include (comprise)" and other forms of the term, for example, a third person singular form "includes (comprises)" and a present participle form "including (comprising)", are interpreted as "open and inclusive", namely, "include but not limited to". In descriptions of this specification, terms such as "one embodiment (one embodiment)", "some embodiments (some embodiments)", "example embodiments (exemplary embodiments)", "example (example)", or "some examples (some examples)" are intended to indicate that a particular feature, structure, material, or characteristic related to this embodiment or example are included in at least one embodiment or example of this disclosure. The foregoing schematic representations of the terms do not necessarily refer to a same embodiment or example. Further, the particular feature, structure, material, or characteristic may be included in any one or more embodiments or examples in any appropriate manner.

In addition, in this application, position terms such as "front" and "back" are defined relative to positions of components in the accompanying drawings. It should be understood that these directional terms are relative concepts used for relative description and clarification, and may change correspondingly based on changes of positions in which components are placed in the accompanying drawings.

The term "and/or" in embodiments of this application describes only an association relationship between associated objects and represents that three relationships may exist. For example, A and/or B may represent the following three cases: Only A exists, both A and B exist, and only B exists. In addition, the character "/" in this specification generally indicates an "or" relationship between the associated objects.

In recent years, with continuous improvement of people's material and cultural living standards, electronic products have increasingly types and functions, and consumers have higher requirements on waterproof performance of electronic products. To meet a waterproof specification of a consumer electronic product, through holes in the electronic products need to be sealed.

It may be understood that the electronic product is an electronic device. Generally, the electronic device may include a plurality of components. When the electronic device is assembled, some through holes for connection are usually disposed. A connector is disposed in the through hole to connect two components, resulting in some gaps between the connector and an inner wall of the through hole and between the adjacent components. If the gaps cannot be sealed, waterproof performance of the electronic device is affected, and consequently, a requirement of the consumer for the electronic device cannot be met.

Generally, to seal the gap of the electronic device, a manner of injecting a sealant into the gap may be used to seal the gap of the electronic device.

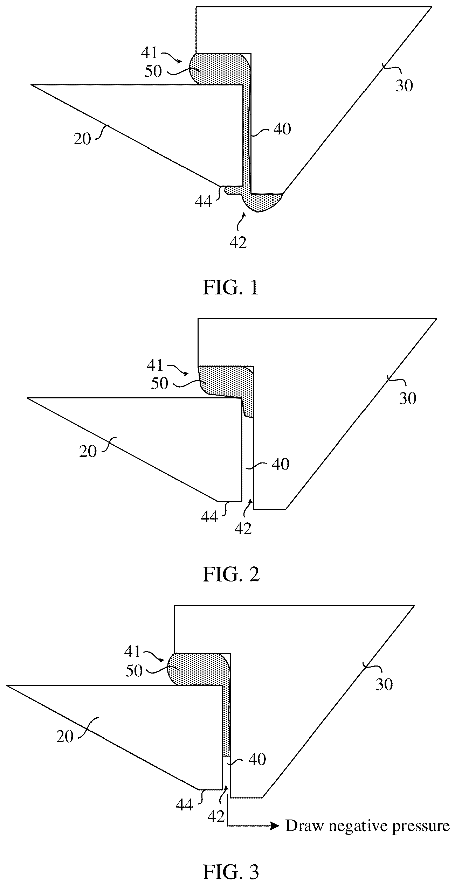

For example, as shown in FIG. 1, an electronic device includes a first component 20 and a second component 30. A gap 40 is formed between the first component 20 and the second component 30. To ensure sealing performance of the electronic device, a sealant 50 needs to be injected into the gap 40 in the electronic device. The sealant may be directly injected into one end of the gap 40, and the sealant 50 flows into the gap 40 based on liquidity of the sealant, to seal the gap 40.

For example, the gap 40 includes a sealant injection end 41 and a non-sealant-injection end 42, and the injection end of the sealant is used as the sealant injection end 41. For example, the sealant injection end 41 of the gap 40 faces an interior of the electronic device. The non-sealant-injection end 42 of the gap 40 faces an appearance surface 44 of the electronic device.

It should be noted that the appearance surface of the electronic device is an outer surface of the electronic device. In other words, when the electronic device is used, a surface that can be seen by a user on the electronic device is the appearance surface. An appearance surface of a mechanical part is a surface facing the user when the first component 20 and the second component 30 are assembled into the electronic device. An appearance surface 44 of each of the first component 20 and the second component 30 is a surface facing the user when the first component 20 and the second component 30 are assembled into the electronic device. It may be understood that, when the first component 20 and the second component 30 are located in the electronic device, the appearance surface 44 may be any surface of the first component 20 and the second component 30.

Still as shown in FIG. 1, when a viscosity of the sealant 50 is low, liquidity of the sealant 50 is good. Consequently, a problem of sealant overflow or sealant leakage easily occurs, resulting in poor aesthetics of the appearance surface of the electronic device. Even in some cases, the sealant 50 completely flows out of the gap 40, and cannot perform any sealing function at all.

As shown in FIG. 2, when a viscosity of the sealant 50 is high, liquidity of the sealant 50 is poor. Consequently, the sealant 50 cannot flow into the gap 40 based on the liquidity of the sealant. Especially when there is an irregular area in the gap 40, or a size of the gap 40 is small, the sealant 50 is accumulated at the sealant injection end of the gap 40, and cannot seal the gap 40 at all.

As shown in FIG. 3, in an embodiment, the sealant may alternatively be injected into the sealant injection end 41 of the gap 40, and negative pressure is applied to the non-sealant-injection end 42 of the gap 40, to suck the sealant 50 into the gap 40, so that the gap 40 is sealed. Although the sealant 50 can flow into the irregular micro-gap 40, bubbles are generated in the sealant 50 in the negative pressure manner. In other words, this reduces bubble discharge performance of the sealant 50, and bubbles exist in the sealant 50 in the gap 40, resulting in unstable sealing performance and easily resulting in water leakage. As a result, waterproof performance of the electronic device is poor.

In addition, the manner of applying the negative pressure to one end of the gap 40 cannot resolve a problem of sealant overflow or sealant leakage of the appearance surface 44 of the first component 20 and the second component 30, resulting in poor aesthetics of the appearance surface 44 of the electronic device.

To resolve the foregoing technical problems, embodiments of this application provide a mechanical part sealing method and an electronic device. In the mechanical part sealing method, one end of a gap is sealed, and a sealant is injected into the other end of the gap, to avoid a problem of sealant overflow or sealant leakage. A mechanical part is first injected with the sealant in a first environment, then the mechanical part is placed in a second environment, and a remaining part of the sealant or all the sealant entering a sealing channel seals and fills the sealing channel based on a pressure difference between the first environment and the second environment, to ensure that positions of an irregular gap and a micro-gap in the sealing channel can be effectively filled.

The following describes in detail the mechanical part sealing method and then electronic device provided in embodiments of this application with reference to the accompanying drawings.

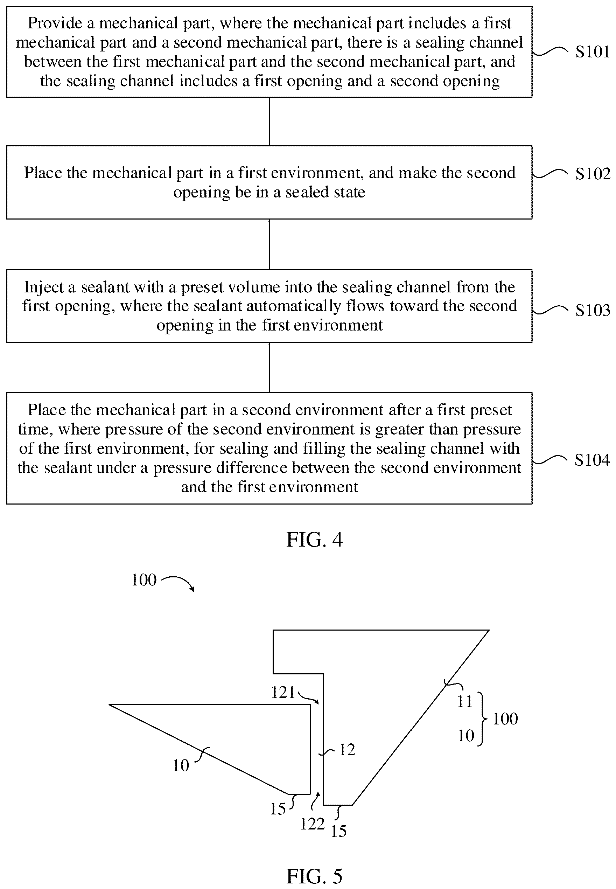

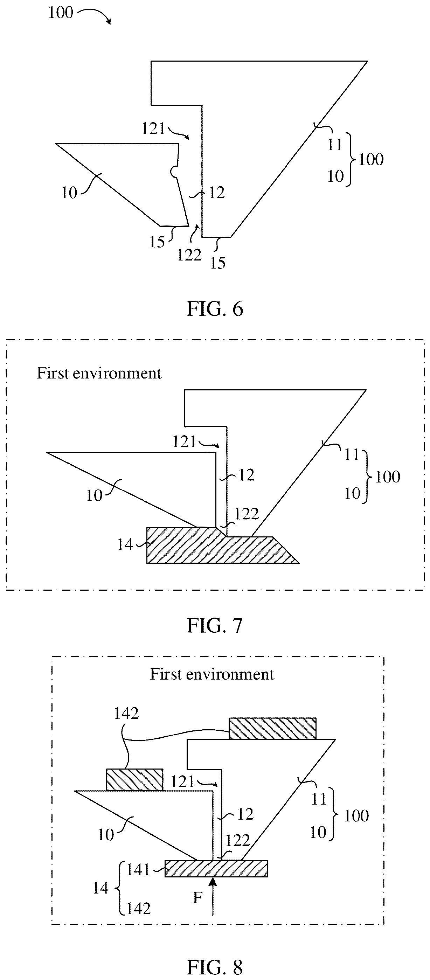

FIG. 4 is a schematic flowchart of a mechanical part sealing method according to an embodiment of this application. FIG. 5 is a diagram of a structure of a mechanical part according to an embodiment of this application. FIG. 6 is a diagram of a structure of a mechanical part according to an embodiment of this application.

An embodiment of this application provides a mechanical part sealing method. As shown in FIG. 4, the sealing method may include the following steps.

S101: Provide a mechanical part, where the mechanical part includes a first mechanical part and a second mechanical part, there is a sealing channel between the first mechanical part and the second mechanical part, and the sealing channel includes a first opening and a second opening.

S102: Place the mechanical part in a first environment, and make the second opening be in a sealed state.

S103: Inject sealant with a preset volume into the sealing channel from the first opening, where the sealant automatically flows toward the second opening in the first environment.

S104: Place the mechanical part in a second environment after a first preset time, where pressure of the second environment is greater than pressure of the first environment, for sealing and filling the sealing channel with the sealant under a pressure difference between the second environment and the first environment.

According to the mechanical part sealing method provided in this embodiment of this application, the second opening of the sealing channel is sealed, so that a problem of sealant overflow or sealant leakage after the sealing channel is sealed can be prevented, and an amount of the sealant can be controlled. The mechanical part is first placed in the first environment, and the sealant with the preset volume is injected into the sealing channel from the first opening, so that the amount of the sealant can be controlled, and the sealant can be injected into the sealing channel.

The mechanical part is placed in the second environment after the first preset time, so that a part or all of the sealant can be injected into the sealing channel when the sealant is in the first environment.

The pressure of the second environment is set to be greater than the pressure of the first environment, so that a remaining part of the sealant or all the sealant entering the sealing channel can seal and fill the sealing channel based on the pressure difference between the second environment and the first environment, to ensure that positions of an irregular gap and a micro-gap in the sealing channel can be effectively filled.

In addition, the sealant fills the sealing channel under positive pressure extrusion. This can reduce a risk of bubbles in the sealant compared with filling by drawing negative pressure.

It should be noted that, for ease of description, in this embodiment of this application, one end, into which the sealant is injected, of the sealing channel is used as a sealant injection end. In this embodiment of this application, the first opening is a sealant injection end. One end, into which the sealant is not injected, of the sealing channel is a non-sealant-injection end. In this embodiment of this application, the second opening is a non-sealant-injection end.

The following describes step S101 in detail.

As shown in FIG. 5, a mechanical part 100 includes a first mechanical part 10 and a second mechanical part 11, there is a sealing channel 12 between the first mechanical part 10 and the second mechanical part 11, and the sealing channel 12 includes a first opening 121 and a second opening 122. The first opening 121 is a sealant injection end of the sealing channel 12, and the second opening 122 is a non-sealant-injection end of the sealing channel 12.

It should be noted that, in step S101, the first mechanical part 10 and the second mechanical part 11 in the mechanical part 100 are not further limited. For example, the mechanical part 100 may be a component of an electronic device. The following uses an example in which the mechanical part 100 is a component of an electronic device for description.

For example, the electronic device may include a display, a middle frame, a flexible circuit board, an adapter, a screw, or a bolt.

In a possible implementation, one of the first mechanical part 10 and the second mechanical part 11 is a display of the electronic device, and the other of the first mechanical part 10 and the second mechanical part 11 is a middle frame of the electronic device. The sealing channel 12 is formed between the display and the middle frame, and the sealing channel 12 is a gap between the display and the middle frame.

One of the first mechanical part 10 and the second mechanical part 11 is disposed as the display, and the other of the first mechanical part 10 and the second mechanical part 11 is disposed as the middle frame of the electronic device. In this way, sealing can be performed between the middle frame and the display, to improve waterproof performance of the electronic device in which the mechanical part 100 is used.

In a possible implementation, one of the first mechanical part 10 and the second mechanical part 11 is a flexible circuit board, and the other of the first mechanical part 10 and the second mechanical part 11 is a middle frame or an adapter of the electronic device. The middle frame or the adapter of the electronic device is provided with a through hole for the flexible circuit board to pass through. During assembly, the flexible circuit board can pass through the through hole, and the flexible circuit board is connected to the middle frame or the adapter. The sealing channel 12 may be a gap between the flexible circuit board and an inner wall of the through hole.

Certainly, in some other embodiments, a connection relationship between the flexible circuit board and the middle frame or the adapter may be in another form. For example, one of the first mechanical part 10 and the second mechanical part 11 is a flexible circuit board, and the other of the first mechanical part 10 and the second mechanical part 11 is a middle frame or an adapter of the electronic device. The sealing channel 12 is formed between the flexible circuit board and the middle frame or the adapter, and the sealing channel 12 is a gap between the flexible circuit board and the middle frame or the adapter.

One of the first mechanical part 10 and the second mechanical part 11 is disposed as the flexible circuit board, and the other of the first mechanical part 10 and the second mechanical part 11 is disposed as the middle frame or the adapter. In this way, sealing can be performed on the through hole on the middle frame or the adapter and the flexible circuit board, to improve waterproof performance of the electronic device in which the mechanical part 100 is used.

In a possible implementation, one of the first mechanical part 10 and the second mechanical part 11 is a screw or a bolt, and the other of the first mechanical part 10 and the second mechanical part 11 is an adapter. The adapter is provided with a threaded hole for the screw or the bolt to pass through. The sealing channel 12 is a gap between the screw or the bolt and an inner wall of the threaded hole.

One of the first mechanical part 10 and the second mechanical part 11 is disposed as the screw or the bolt, and the other of the first mechanical part 10 and the second mechanical part 11 is disposed as the adapter. In this way, sealing can be performed on the threaded hole on the adapter and the bolt or the screw, to improve waterproof performance of the electronic device in which the mechanical part 100 is used.

It should be noted that the adapter may be of a hinge structure, or may be another adapter configured to connect two components. A specific structure of the adapter is not further limited in embodiments of this application.

In addition, in another embodiment, the first mechanical part 10 and the second mechanical part 11 include but are not limited to the foregoing mechanical parts. In another embodiment, the first mechanical part 10 and the second mechanical part 11 may alternatively be other components of the electronic device, provided that the foregoing sealing channel 12 is formed between the first mechanical part 10 and the second mechanical part 11.

In a possible implementation, providing the mechanical part 100 includes: forming an appearance surface 15 on at least one of the first mechanical part 10 and the second mechanical part 11. The second opening 122 extends to the appearance surface 15.

For example, an appearance surface 15 is formed on each of the first mechanical part 10 and the second mechanical part 11, for example, the display and the middle frame of the electronic device. Alternatively, an appearance surface 15 is formed on one of the first mechanical part 10 and the second mechanical part 11, for example, the middle frame and the flexible circuit board of the electronic device.

It should be noted that the appearance surface 15 is an outer surface of the electronic device. In other words, when the electronic device is used, a surface that can be seen by a user on the electronic device is the appearance surface 15. In other words, at least one of the first mechanical part 10 and the second mechanical part 11 is the outer surface of the electronic device.

The appearance surface 15 is formed on at least one of the first mechanical part 10 and the second mechanical part 11, and the second opening 122 extends to the appearance surface 15. Therefore, because the second opening 122 is in the sealed state during sealant injection, it can be ensured that there is no problem of sealant leakage or sealant overflow on the appearance surface 15 of the mechanical part 100 and that the appearance surface 15 is flat and beautiful.

It should be noted that a shape of the sealing channel 12 is not further limited in embodiments of this application. It may be understood that the shape of the sealing channel 12 is related to shapes of the first mechanical part 10 and the second mechanical part 11. For example, as shown in FIG. 5, when partial structures that are of the first mechanical part 10 and the second mechanical part 11 and that form the sealing channel 12 are flat planes, the sealing channel 12 may be a channel with a flat inner wall. As shown in FIG. 6, when partial structures that are of the first mechanical part 10 and the second mechanical part 11 and that form the sealing channel 12 are bent or irregular, the sealing channel 12 is a channel with an uneven interior, that is, the sealing channel 12 has an irregular shape.

In a possible implementation, as shown in FIG. 6, a size of the first opening 121 of the sealing channel 12 may be set to be greater than a size of the second opening 122.

The size of the first opening 121 is set to be greater than that of the second opening 122, so that when the sealant 13 is injected into the sealing channel 12 from the first opening 121, the sealant 13 can be conveniently injected into the sealing channel 12 from the first opening 121. This improves sealing efficiency of the mechanical part 100. Because the second opening 122 is away from the appearance surface 15 of the mechanical part 100, setting the size of the second opening 122 to be large does not affect the appearance surface 15 of the mechanical part 100.

In some embodiments, step S102 may be specifically: first placing the mechanical part 100 in the first environment, and then sealing the second opening 122. Certainly, in another embodiment, step S102 may alternatively be specifically: first sealing the second opening 122, and then placing the mechanical part 100 whose second opening 122 is in the sealed state in the first environment. A sequence of sealing the second opening 122 and placing the mechanical part 100 in the first environment is not further limited in embodiments of this application. After step S102 is performed, the mechanical part 100 is shown in FIG. 7, and the second opening 122 of the sealing channel 12 of the mechanical part 100 is in the sealed state.

The following describes a manner of sealing the second opening 122.

In a possible implementation, before or after placing the mechanical part 100 in the first environment, the method may further include: disposing, at the second opening 122, a sealing structure 14 used to seal the second opening 122, for the second opening 122 to be in the sealed state.

The sealing structure 14 used to seal the second opening 122 is disposed at the second opening 122, so that the second opening 122 is in the sealed state. This can ensure that there is no problem of sealant leakage or sealant overflow at the second opening 122, and can ensure that an outer side of the second opening 122 is flat. In this way, when the second opening 122 faces the appearance surface 15 of the mechanical part 100, neatness and aesthetics of the appearance surface 15 can be ensured.

It should be noted that, in different scenarios, different sealing structures 14 may be selected to seal the second opening 122. For example, when the non-sealant-injection end of the sealing channel 12 is in an irregular shape, the sealing structure 14 may be set to include a peelable sealant 13. The second opening 122 is sealed by pasting the peelable sealant 13 at the second opening 122. Because a shape of the peelable sealant 13 may change with a shape of the second opening 122, sealing effect at the second opening 122 can be improved. In addition, the peelable sealant 13 is easy to remove, and the sealing structure 14 can be removed after the sealing channel 12 is sealed. This can reduce difficulty in removing the sealing structure 14, and further reduce sealing costs of the mechanical part 100.

When the non-sealant-injection end of the sealing channel 12 is in a regular shape, the sealing structure 14 may be set to a structure including a fixture. A partial structure of the fixture is disposed at the second opening 122, and is connected to the second opening 122 in a sealing manner.

For example, as shown in FIG. 8, the second opening 122 of the sealing channel 12 is flush with the first mechanical part 10 and the second mechanical part 11, and the fixture includes a sealing part 141 and a fastening part 142. The mechanical part 100 is fastened to the fastening part 142 of the fixture, and the sealing part 141 of the fixture is located at the second opening 122. The second opening 122 can be sealed by clamping the sealing part 141 in a direction close to the second opening 122 (F in the figure represents a clamping force). Certainly, in another embodiment, the second opening 122 may alternatively be sealed via the fixture through another operation. A specific operation of sealing the second opening 122 via the fixture is not further limited in embodiments of this application. In addition, a specific structure of the fixture is not further limited.

The sealing structure 14 is set to include the fixture, so that the second opening 122 can be sealed through a specific operation provided that the mechanical part 100 is placed on the fixture. This can simplify a procedure of sealing the second opening 122 of the sealing channel 12, thereby improving sealing efficiency of the mechanical part 100, and facilitating industrial production.

The following describes step S103 in detail.

Injecting the sealant with the preset volume 13 into the sealing channel 12 from the first opening 121 may specifically include: obtaining the sealant with the preset volume 13, and then injecting the sealant with the preset volume 13 into the first opening 121.

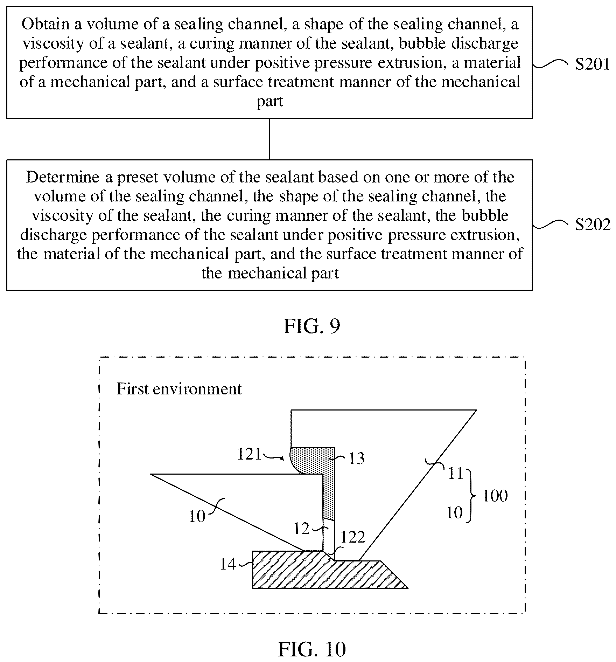

As shown in FIG. 9, obtaining the sealant with the preset volume 13 may include the following steps.

S201: Obtain a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part.

S202: Determine the preset volume of the sealant based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

It should be noted that, because the preset volume of the sealant is related to the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part, the preset volume of the sealant obtained by obtaining these parameters: the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part is accurate. This can accurately control the amount of the sealant, thereby ensuring sealing stability and reducing costs.

For example, the preset volume of the sealant may be determined based on one of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the preset volume of the sealant may be determined based on all of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the preset volume of the sealant may be determined based on the volume of the sealing channel, the viscosity of the sealant, and the curing manner of the sealant. A quantity of parameters for determining the preset volume of the sealant is not further limited in embodiments of this application.

Certainly, in some other embodiments, the preset volume of the sealant may alternatively be determined by obtaining another parameter.

For example, a method for obtaining the preset volume of the sealant may alternatively include: obtaining one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and
determining the preset volume of the sealant based on data information of one or more of the obtained volume of the sealing channel, shape of the sealing channel, viscosity of the sealant, curing manner of the sealant, bubble discharge performance of the sealant under positive pressure extrusion, material of the mechanical part, and surface treatment manner of the mechanical part.

A specific manner of obtaining the preset volume of the sealant is not further limited in embodiments of this application.

It should be noted that the preset volume of the sealant should be determined before the sealant with the preset volume is injected into the sealing channel from the first opening. Before the sealant with the preset volume is injected into the sealing channel from the first opening, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the preset volume of the sealant is determined based on one or more of the foregoing parameters. This can improve accuracy of the amount of the sealant in the sealing channel, can avoid sealant overflow, and can also avoid poor sealing effect caused by insufficiency of a sealing member, thereby ensuring sealing performance of the sealing channel 12 and improving sealing efficiency.

Certainly, in some other embodiments, the preset volume of the sealant may alternatively be obtained after the mechanical part is provided. A time for obtaining the preset volume of the sealant is not further limited in embodiments of this application.

In step S103, when the sealant is injected into the first opening 121 of the sealing channel 12, the mechanical part 100 is shown in FIG. 10, and the sealant 13 automatically flows toward the second opening 122 based on liquidity of the sealant.

The following describes step S104.

Placing the mechanical part 100 in the second environment after the first preset time specifically includes: obtaining the first preset time, and then placing the mechanical part 100 in the second environment after the first preset time.

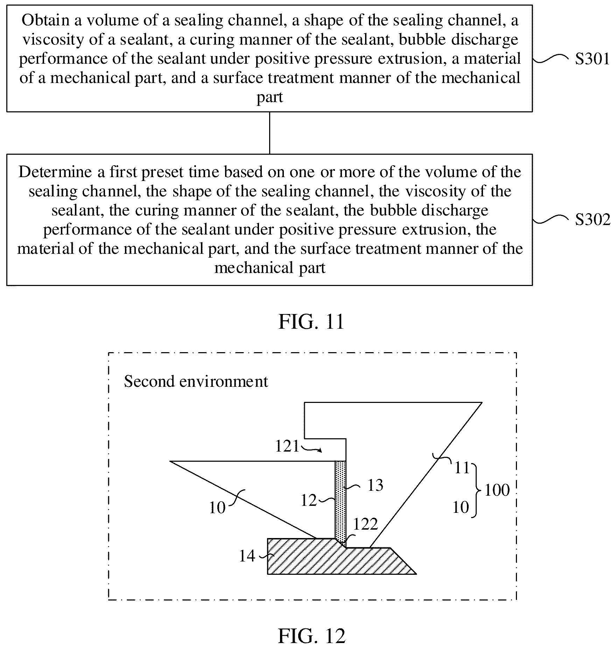

As shown in FIG. 11, obtaining the first preset time specifically includes the following steps.

S301: Obtain a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part.

S302: Determine the first preset time based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

It should be noted that, because the first preset time is related to the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part, the first preset time obtained by obtaining these parameters: the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part is accurate. This can ensure that most or all of the sealant enters the sealing channel within the first preset time, the mechanical part is placed in the second environment, and the sealant can be compacted in the sealing channel, so as to completely seal the sealing channel.

For example, the first preset time may be determined based on one of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the first preset time may be determined based on all of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the first preset time may be determined based on the volume of the sealing channel, the viscosity of the sealant, and the curing manner of the sealant. A quantity of parameters for determining the first preset time is not further limited in embodiments of this application.

Certainly, in some other embodiments, the first preset time may alternatively be determined by obtaining another parameter.

For example, a method for obtaining the first preset time may alternatively include: obtaining one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and
determining the first preset time based on data information of one or more of the obtained volume of the sealing channel, shape of the sealing channel, viscosity of the sealant, curing manner of the sealant, bubble discharge performance of the sealant under positive pressure extrusion, material of the mechanical part, and surface treatment manner of the mechanical part.

A specific manner of obtaining the first preset time is not further limited in embodiments of this application.

It should be noted that the first preset time should be determined before the sealant with the preset volume is injected into the sealing channel from the first opening. Before the sealant with the preset volume is injected into the sealing channel from the first opening, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the first preset time is determined based on one or more of the foregoing parameters. This can improve accuracy of a sealant injection time of the mechanical part in the first environment, thereby ensuring sealing performance of the sealing channel and improving sealing efficiency.

In step S104, after the mechanical part 100 is placed in the second environment, the mechanical part 100 is shown in FIG. 12, and the sealant 13 seals and fills the sealing channel 12 under the pressure difference between the second environment and the first environment.

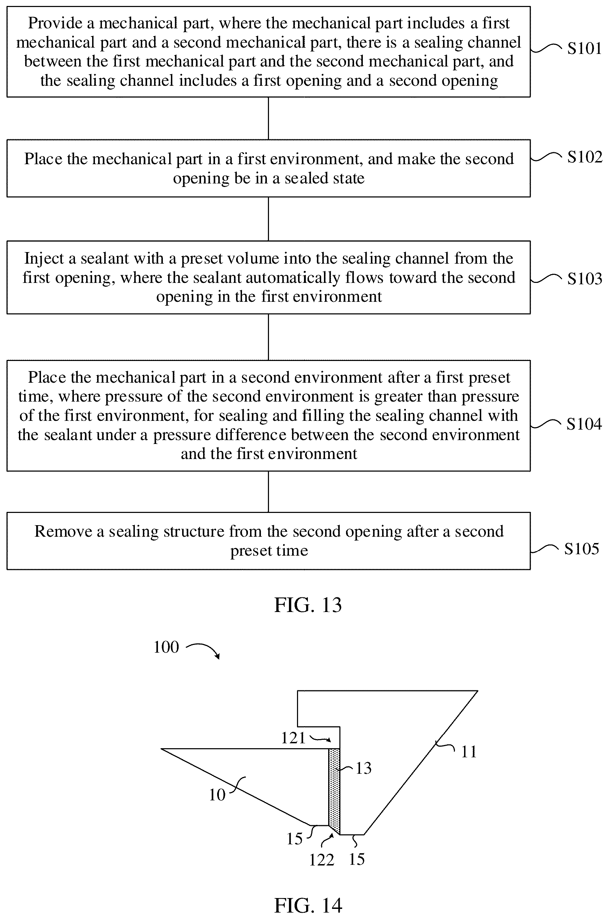

In some other embodiments, as shown in FIG. 13, after the mechanical part 100 is placed in the second environment, the method further includes: S105: Remove the sealing structure from the second opening after a second preset time.

After step S105 is performed, the mechanical part 100 is shown in FIG. 14, the sealing channel 12 of the mechanical part 100 is sealed, and the sealing structure 14 at the second opening 122 is removed. The first mechanical part 10 and the second mechanical part 11 are in a sealed state. In addition, the second opening 122 is flat, and there is no problem of sealant overflow or sealant leakage.

After the mechanical part 100 is placed in the second environment, the sealing mechanism is removed from the second opening 122 after the second preset time, so that there is no redundant component on the mechanical part 100, and a structure of the mechanical part 100 is simplified. In addition, when the second opening 122 faces the appearance surface 15 of the mechanical part 100, aesthetics of the mechanical part 100 can be improved.

A manner of determining the second preset time may be the same as a manner of determining the first preset time. Certainly, in some other embodiments, the second preset time may alternatively be set to a time required for the sealant 13 to be completely solidified. This can ensure that the sealant 13 is completely solidified, and ensure, when the sealing structure 14 is removed, that the sealing performance of the sealant 13 is not damaged.

The following describes the pressure of the first environment and the pressure of the second environment.

In a possible implementation, the first environment is a negative pressure environment. Because the pressure of the second environment is greater than that of the first environment, in a possible implementation, the second environment may be set to a standard atmospheric pressure environment or an air environment. In this way, a pressure difference can be formed between the second environment and the first environment, to ensure that positions of an irregular gap and a micro-gap in the sealing channel 12 can be effectively filled. In addition, the sealant 13 fills the sealing channel 12 under positive pressure extrusion. This can reduce a risk of bubbles in the sealant 13 compared with filling by drawing negative pressure. In addition, only a negative pressure environment needs to be provided, and pressure relief needs to be performed on the first environment after the first preset time. The operation is simple, and a step of sealing the mechanical part 100 can be simplified. In addition, the negative pressure environment is easy to provide, and the air environment is also easy to provide. Therefore, sealing costs of the mechanical part 100 can be reduced.

It should be noted that specific atmospheric pressure of the air environment is related to a temperature, an altitude, and the like of the environment. In this embodiment of this application, the air environment is an air environment in daily life, and may also be referred to as an external environment or the like, namely, a natural environment. Therefore, the atmospheric pressure of the air environment is close to standard atmospheric pressure.

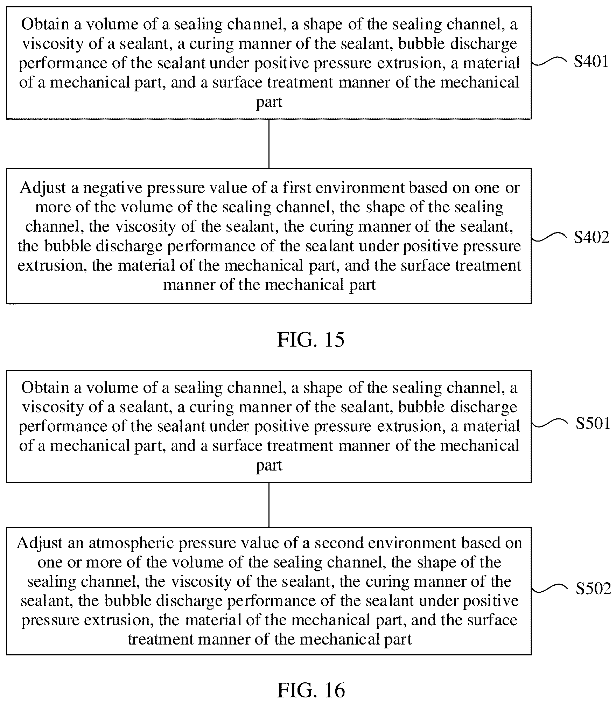

As shown in FIG. 15, when the first environment is a negative pressure environment, a method for obtaining a negative pressure value of the first environment may include the following steps.

S401: Obtain a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part.

S402: Adjust the negative pressure value of the first environment based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

It should be noted that, because the negative pressure value of the first environment is related to the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part, the negative pressure value of the first environment obtained by obtaining these parameters: the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part is accurate. This can ensure that the bubble discharge performance of the sealant entering the sealing channel in the first environment is good, thereby ensuring sealing stability of the sealing channel.

For example, the negative pressure value of the first environment may be determined based on one of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the negative pressure value of the first environment may be determined based on all of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the negative pressure value of the first environment may be determined based on the volume of the sealing channel, the viscosity of the sealant, and the curing manner of the sealant. A quantity of parameters for determining the negative pressure value of the first environment is not further limited in embodiments of this application.

Certainly, in some other embodiments, the negative pressure value of the first environment may alternatively be determined by obtaining another parameter.

For example, a method for obtaining the negative pressure value of the first environment may alternatively include: obtaining one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and
determining the negative pressure value of the first environment based on data information of one or more of the obtained volume of the sealing channel, shape of the sealing channel, viscosity of the sealant, curing manner of the sealant, bubble discharge performance of the sealant under positive pressure extrusion, material of the mechanical part, and surface treatment manner of the mechanical part.

A specific manner of obtaining the negative pressure value of the first environment is not further limited in embodiments of this application.

It should be noted that, when the first environment is the negative pressure environment, the negative pressure value of the first environment may be obtained before the sealant with the preset volume 13 is injected into the sealing channel 12 from the first opening 121. Before the sealant with the preset volume 13 is injected into the sealing channel 12 from the first opening 121, the volume of the sealing channel, the viscosity of the sealant, the curing manner of the sealant, the bubble discharge performance of the sealant under positive pressure extrusion, and the material of the mechanical part are obtained, and the negative pressure value of the first environment is adjusted based on one or more of the foregoing parameters. This can improve accuracy of the negative pressure value of the first environment, thereby improving sealing efficiency.

In some other embodiments, the first environment may alternatively be set to a standard atmospheric pressure environment or an air environment.

When the first environment is set to a standard atmospheric pressure environment or an air environment, the second environment may be set to an environment whose atmospheric pressure is greater than that of the standard atmospheric pressure environment or the air environment. In this way, a pressure difference can be formed between the second environment and the first environment, to ensure that positions of an irregular gap and a micro-gap in the sealing channel 12 can be effectively filled. In addition, the sealant 13 fills the sealing channel 12 under positive pressure extrusion. This can reduce a risk of bubbles in the sealant 13 compared with filling by drawing negative pressure. In addition, the standard atmospheric pressure environment or the air environment is easy to obtain, and the second environment can be obtained only by pressurizing the first environment. The operation is simple, and sealing costs of the mechanical part 100 can be reduced.

As shown in FIG. 16, when the first environment is set to a standard atmospheric pressure environment or an air environment, a method for obtaining an atmospheric pressure value of the second environment may include the following steps.

S501: Obtain a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part.

S502: Adjust the atmospheric pressure value of the second environment based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

It should be noted that, because the atmospheric pressure value of the second environment is related to the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part, the atmospheric pressure value of the second environment obtained by obtaining these parameters: the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part is accurate. This can ensure that the sealant 13 can be compacted in the sealing channel 12 under atmospheric pressure of the second environment, to completely seal the sealing channel 12.

For example, the atmospheric pressure value of the second environment may be determined based on one of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the atmospheric pressure value of the second environment may be determined based on all of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. Alternatively, the atmospheric pressure value of the second environment may be determined based on both the viscosity of the sealant and the curing manner of the sealant. A quantity of parameters for determining the atmospheric pressure value of the second environment is not further limited in embodiments of this application.

Certainly, in some other embodiments, the atmospheric pressure value of the second environment may alternatively be determined by obtaining another parameter.

For example, a method for obtaining the atmospheric pressure value of the second environment may alternatively include: obtaining one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and
determining the atmospheric pressure value of the second environment based on data information of one or more of the obtained volume of the sealing channel, shape of the sealing channel, viscosity of the sealant, curing manner of the sealant, bubble discharge performance of the sealant under positive pressure extrusion, material of the mechanical part, and surface treatment manner of the mechanical part.

A specific manner of obtaining the atmospheric pressure value of the second environment is not further limited in embodiments of this application.

It should be noted that, when the first environment is the standard atmospheric pressure environment or the air environment, the atmospheric pressure value of the second environment may be obtained after the sealant with the preset volume 13 is injected into the sealing channel 12 from the first opening 121. After the sealant with the preset volume 13 is injected into the sealing channel 12 from the first opening 121, the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part are obtained, and the atmospheric pressure value of the second environment is adjusted based on one or more of the foregoing parameters. This can improve accuracy of the atmospheric pressure value of the second environment, thereby improving sealing efficiency.

It should be noted that, a time for obtaining the preset volume of the sealant, the first preset time, the atmospheric pressure value of the first environment, and the atmospheric pressure value of the second environment is not further limited in embodiments of this application, for example, as described in the steps in the foregoing embodiments. Alternatively, all required parameters, for example, the preset volume of the sealant, the first preset time, the atmospheric pressure value of the first environment, and the atmospheric pressure value of the second environment, may be obtained in the first step of the entire sealing method, and then, the sealing step is performed. A time for obtaining the preset volume of the sealant, the first preset time, the atmospheric pressure value of the first environment, the atmospheric pressure value of the second environment, and the second preset time is not further limited in embodiments of this application.

It should be noted that, regardless of whether the first environment is set to a negative pressure environment and the second environment is set to an air environment, or the first environment is set to an air environment and the second environment is set to an environment whose atmospheric pressure is greater than that of the air environment, one environment may be an air environment in the sealant injection process, and the air environment is easy to obtain. Therefore, this can reduce process steps of sealant injection, thereby reducing sealant injection costs.

It should be noted that the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part affect parameters such as a sealant injection time, a sealant injection amount, and atmospheric pressure of sealant injection of the mechanical part. However, the parameters such as the sealant injection time, the sealant injection amount, and the atmospheric pressure of sealant injection affect the preset volume of the sealant, the first preset time, the atmospheric pressure value of the first environment, and the atmospheric pressure value of the second environment.

Therefore, the preset volume of the sealant, the first preset time, the atmospheric pressure value of the first environment, and the atmospheric pressure value of the second environment are determined based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part. This can improve accuracy of sealant injection, reduce a sealant waste, and further avoid a problem that the sealant cannot implement complete sealing due to insufficiency.

It should be noted that, in the foregoing embodiment, the material of the mechanical part includes a material of the first mechanical part and a material of the second mechanical part. The surface treatment manner of the mechanical part includes a surface treatment manner of the first mechanical part and a surface treatment manner of the second mechanical part. In a process in which the sealant flows from the first opening to the second opening of the sealing channel, a part of the sealant may penetrate into the mechanical part from the surface of the mechanical part, and a part of the sealant may be stuck on the surface of the mechanical part. This affects the preset volume of the sealant, the first preset time, the atmospheric pressure value of the first environment, and the atmospheric pressure value of the second environment.

However, the material and the surface treatment manner of the mechanical part affect the fluidity and wettability of the sealant on the surface of the mechanical part. The wettability may be understood as a capability of the sealant to penetrate into the mechanical part from the surface of the mechanical part. If the wettability is good, it indicates that most of the sealant can penetrate into the mechanical part from the surface of the mechanical part. If the wettability is poor, it indicates that a small part of the sealant can penetrate into the mechanical part from the surface of the mechanical part. In other words, the material and the surface treatment manner of the mechanical part may be the preset volume of the sealant, the first preset time, the atmospheric pressure value of the first environment, and the atmospheric pressure value of the second environment.

For example, when the material of the mechanical part is plastic and metal, the sealant has different fluidity and wettability on the surface of the mechanical part. Therefore, the preset volume of the sealant, the first preset time, the atmospheric pressure value of the first environment, and the atmospheric pressure value of the second environment are determined based on the material of the mechanical part. This can improve accuracy of the preset volume of the sealant, the first preset time, the atmospheric pressure value of the first environment, and the atmospheric pressure value of the second environment, avoid a sealant waste, shorten a time, and further avoid a problem that the sealant cannot implement complete sealing due to insufficiency.

Similarly, when surface treatment manners of the mechanical part are different, the sealant has different fluidity and wettability on the surface of the mechanical part. Therefore, the preset volume of the sealant, the first preset time, the atmospheric pressure value of the first environment, and the atmospheric pressure value of the second environment are determined based on the material of the mechanical part. This can improve accuracy of sealant injection, reduce a sealant waste, and further avoid a problem that the sealant cannot implement complete sealing due to insufficiency.

For example, the surface treatment manner of the mechanical part may include electroplating, coating, chemical oxidation, and thermal spraying. The surface treatment manner of the mechanical part is not further limited in embodiments of this application.

It should be noted that the volume and the shape of the sealing channel may affect the preset volume of the sealant, the first preset time, the atmospheric pressure value of the first environment, and the atmospheric pressure value of the second environment. For example, to achieve same sealing effect, parameters such as the preset volume of the sealant, the first preset time, the atmospheric pressure value of the first environment, and the atmospheric pressure value of the second environment need to be set to be different for a sealing channel with a large volume and a sealing channel with a small volume. For example, a preset volume of the sealant for the sealing channel with the large volume is greater than a preset volume of the sealant for the sealing channel with the small volume.

In addition, the shape of the sealing channel may be an annular gap, or may be an annular gap with a bend in the middle (as shown in FIG. 6), or may be a narrow gap. The shape of the sealing channel affects a time for the sealant to enter the sealing channel. A longer sealing time indicates a longer time for the sealant to flow on a surface of the sealing channel, a longer sealant injection time, and a larger amount of sealant that penetrates into an inner wall of the mechanical part. Therefore, the shape of the sealing channel also affects the amount of the sealant and the sealant injection time.

In addition, the viscosity of the sealant, the curing manner of the sealant, and the bubble discharge performance of the sealant under positive pressure extrusion all affect the preset volume of the sealant, the first preset time, the atmospheric pressure value of the first environment, and the atmospheric pressure value of the second environment. For example, if the viscosity of the sealing member is high, the first preset time for sealant injection may be long. In addition, the viscosity of the sealant, the curing manner of the sealant, and the bubble discharge performance of the sealant under positive pressure extrusion are related to a type of the sealant. Therefore, these parameters may be determined based on the type of the sealant. Specific manners of obtaining the preset volume, the first preset time, the atmospheric pressure value of the first environment, and the atmospheric pressure value of the second environment are not further limited in embodiments of this application.

Embodiments of this application further provide an electronic device. The electronic device may include but is not limited to a fixed terminal or mobile terminal having a camera lens, for example, a mobile phone, a tablet computer, a notebook computer, an ultra-mobile personal computer (ultra-mobile personal computer, UMPC), a handheld computer, a touch television, a walkie-talkie, a netbook, a POS terminal, a personal digital assistant (personal digital assistant, PDA), a wearable device, and a virtual reality device.

In this embodiment of this application, the electronic device may include a mechanical part 100. The mechanical part 100 may include a first mechanical part 10 and a second mechanical part 11. There is a sealing channel 12 between the first mechanical part 10 and the second mechanical part 11 (as shown in FIG. 5). A sealant 13 is disposed in the sealing channel 12, and the sealant 13 seals the sealing channel 12 by using the mechanical part sealing method provided in any one of the foregoing embodiments, as shown in FIG. 14.

The sealant in the sealing channel of the mechanical part of the electronic device seals the sealing channel by using the foregoing mechanical part sealing method. This can improve sealing performance of the mechanical part, thereby improving waterproof performance of the electronic device. In addition, appearance aesthetics of the electronic device can be further ensured.

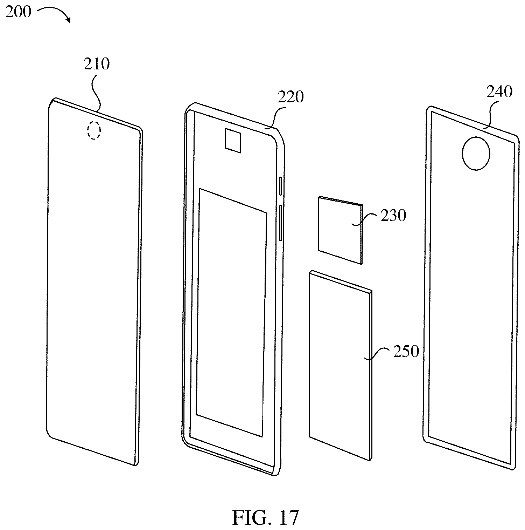

For example, as shown in FIG. 17, an example in which the electronic device 200 is a mobile phone is used for description. The electronic device 200 may include a display 210, a middle frame 220, a flexible circuit board 230, a housing 240, a battery 250, an adapter, a screw or a bolt, and the like. During assembly, the display 210 may be disposed opposite to the housing 240, the middle frame 220 is disposed between the housing 240 and the display 210, and the battery 250 and the flexible circuit board 230 are disposed between the middle frame 220 and the housing 240.

In a possible implementation, one of the first mechanical part 10 and the second mechanical part 11 is a display of the electronic device, and the other of the first mechanical part 10 and the second mechanical part 11 is a middle frame of the electronic device. The sealing channel 12 is a gap (not shown in the figure) between the display and the middle frame.

The first mechanical part 10 and the second mechanical part 11 are disposed as the display and the middle frame respectively. This can improve sealing performance between the display and the middle frame, thereby improving waterproof performance of the electronic device.

In a possible implementation, each of the display and the middle frame has an appearance surface. An opening at one end of the sealing channel 12 extends to between the appearance surface of the display and the appearance surface of the middle frame, and an opening at the other end of the sealing channel faces an interior of the electronic device.

Each of the display and the middle frame is provided with the appearance surface, the opening at the one end of the sealing channel 12 extends to between the appearance surface of the display and the appearance surface of the middle frame, and the opening at the other end of the sealing channel faces the interior of the electronic device. This can seal one end that is of the sealing channel 12 and that faces the appearance surface of the display and the appearance surface of the middle frame while sealing the sealing channel 12, thereby ensuring aesthetics of an appearance surface of the electronic device.

In a possible implementation, one of the first mechanical part 10 and the second mechanical part 11 is a flexible circuit board of the electronic device, and the other of the first mechanical part 10 and the second mechanical part 11 is a middle frame or an adapter of the electronic device. The middle frame or the adapter of the electronic device is provided with a through hole for the flexible circuit board to pass through. The sealing channel 12 is a gap between the flexible circuit board and an inner wall of the through hole.

Certainly, in some other embodiments, a connection relationship between the flexible circuit board and the middle frame or the adapter may be in another form. For example, one of the first mechanical part 10 and the second mechanical part 11 is a flexible circuit board, and the other of the first mechanical part 10 and the second mechanical part 11 is a middle frame or an adapter of the electronic device. The sealing channel 12 is formed between the flexible circuit board and the middle frame or the adapter, and the sealing channel 12 is a gap between the flexible circuit board and the middle frame or the adapter.

One of the first mechanical part 10 and the second mechanical part 11 is disposed as the flexible circuit board, and the other of the first mechanical part 10 and the second mechanical part 11 is disposed as the middle frame or the adapter. In this way, sealing can be performed on the through hole on the middle frame or the adapter and the flexible circuit board, to improve waterproof performance of the electronic device in which the mechanical part is used.

In a possible implementation, one of the first mechanical part 10 and the second mechanical part 11 is a screw or a bolt, and the other of the first mechanical part 10 and the second mechanical part 11 is an adapter. The adapter is provided with a threaded hole for the screw or the bolt to pass through. The sealing channel 12 is a gap between the screw or the bolt and an inner wall of the threaded hole.

One of the first mechanical part 10 and the second mechanical part 11 is disposed as the screw or the bolt, and the other of the first mechanical part 10 and the second mechanical part 11 is disposed as the adapter. In this way, sealing can be performed on the threaded hole on the adapter and the bolt or the screw, to improve waterproof performance of the electronic device in which the mechanical part is used.

It should be noted that the adapter may be of a hinge structure, or may be another adapter configured to connect two components. A specific structure of the adapter is not further limited in embodiments of this application.

In addition, in another embodiment, the first mechanical part 10 and the second mechanical part 11 may alternatively be other components of the electronic device, provided that the foregoing sealing channel 12 is formed between the first mechanical part 10 and the second mechanical part 11.

In a possible implementation, the sealing channel 12 has a sealing end and a sealant injection end. A size of the sealant injection end is greater than a size of the sealing end (as shown in FIG. 6), and the sealant injection end is located inside the electronic device. It should be noted that the sealing end in this embodiment of this application is the non-sealant-injection end in the foregoing embodiment.

The size of the sealant injection end is set to be greater than that of the sealing end, so that when the sealant 13 is injected into the sealing channel 12 from the sealant injection end, the sealant 13 can be conveniently injected into the sealing channel 12 from the sealant injection end. This improves sealing efficiency of the mechanical part. Because the sealant injection end is disposed inside the electronic device, setting the size of the sealant injection end to be large does not affect the appearance surface of the mechanical part. In addition, when the sealing end faces the appearance surface of the mechanical part, the aesthetics of the appearance surface of the electronic device can be improved.

It should be noted that the first mechanical part 10 and the second mechanical part 11 include but are not limited to the display and middle frame, or the flexible circuit board and the middle frame and the adapter, or the screw or the bolt and the adapter. In another embodiment, the first mechanical part 10 and the second mechanical part 11 may alternatively be of other structures. Specific structures of the first mechanical part 10 and the second mechanical part 11 are not further limited in embodiments of this application. Provided that there is a sealing channel that needs to be sealed between the first mechanical part 10 and the second mechanical part 11, this falls within the protection scope of embodiments of this application.

In the descriptions of embodiments of this application, it should be noted that, unless otherwise clearly specified and limited, the term "mounting", "connection to", or "connection" should be understood in a broad sense, for example, may be fastening, or may be an indirect connection through an intermediate medium, or may be internal communication between two elements or an interaction relationship between two elements. A person of ordinary skill in the art may understand specific meanings of the foregoing terms in embodiments of this application based on specific cases.

In the specification, claims, and accompanying drawings of embodiments of this application, the terms "first", "second", "third", "fourth", and the like (if existent) are intended to distinguish between similar objects but do not necessarily indicate a specific order or sequence.

Finally, it should be noted that the foregoing embodiments are merely used to describe the technical solutions in embodiments of this application, but not to limit the technical solutions. Although embodiments of this application are described in detail with reference to the foregoing embodiments, a person of ordinary skill in the art should understand that the technical solutions recorded in the foregoing embodiments may still be modified, or some or all of technical features thereof may be equivalently replaced. However, these modifications or replacements do not depart from the scope of the technical solutions in embodiments of this application.

## Claims

1. A mechanical part sealing method, wherein the sealing method comprises:
providing a mechanical part, wherein the mechanical part comprises a first mechanical part and a second mechanical part, there is a sealing channel between the first mechanical part and the second mechanical part, and the sealing channel comprises a first opening and a second opening;
placing the mechanical part in a first environment, and making the second opening be in a sealed state;
injecting sealant with a preset volume into the sealing channel from the first opening, wherein the sealant automatically flows toward the second opening in the first environment; and
placing the mechanical part in a second environment after a first preset time, wherein pressure of the second environment is greater than pressure of the first environment, for sealing and filling the sealing channel with the sealant under a pressure difference between the second environment and the first environment.

2. The mechanical part sealing method according to claim 1, wherein before or after placing the mechanical part in the first environment, the method further comprises:
disposing, at the second opening, a sealing structure used to seal the second opening, for the second opening to be in the sealed state.

3. The mechanical part sealing method according to claim 2, wherein after placing the mechanical part in the second environment, the method further comprises:
removing the sealing structure from the second opening after a second preset time.

4. The mechanical part sealing method according to claim 2 or 3, wherein the sealing structure comprises a peelable sealant.

5. The mechanical part sealing method according to claim 2 or 3, wherein the sealing structure comprises a fixture; and
a partial structure of the fixture is disposed at the second opening, and is connected to the second opening in a sealing manner.

6. The mechanical part sealing method according to any one of claims 1 to 5, wherein providing the mechanical part comprises:
forming an appearance surface on at least one of the first mechanical part and the second mechanical part; and
extending the second opening to the appearance surface.

7. The mechanical part sealing method according to any one of claims 1 to 6, wherein the first environment is a negative pressure environment; or
the first environment is a standard atmospheric pressure environment or an air environment.

8. The mechanical part sealing method according to claim 7, wherein when the first environment is a negative pressure environment,
before injecting the sealant with the preset volume into the sealing channel from the first opening, the method further comprises:
obtaining a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part; and
adjusting a negative pressure value of the first environment based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

9. The mechanical part sealing method according to claim 7, wherein when the first environment is a standard atmospheric pressure environment or an air environment,
after injecting the sealant with the preset volume into the sealing channel from the first opening, the method further comprises:
obtaining a volume of the sealing channel, a shape of the sealing channel, a viscosity of the sealant, a curing manner of the sealant, bubble discharge performance of the sealant under positive pressure extrusion, a material of the mechanical part, and a surface treatment manner of the mechanical part; and
adjusting an atmospheric pressure value of the second environment based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

10. The mechanical part sealing method according to any one of claims 1 to 9, wherein before injecting the sealant with the preset volume into the sealing channel from the first opening, the method further comprises:
obtaining the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part; and
determining the first preset time based on one or more of the volume of the sealing channel, the shape of the sealing channel, the viscosity of the sealant, the curing manner of the sealant, the bubble discharge performance of the sealant under positive pressure extrusion, the material of the mechanical part, and the surface treatment manner of the mechanical part.

11. The mechanical part sealing method according to any one of claims 1 to 10, wherein before injecting the sealant with the preset volume into the sealing channel from the first opening, the method further comprises:
obtaining the volume of the sealing channel, the viscosity of the sealant, the curing manner of the sealant, the bubble discharge performance of the sealant under positive pressure extrusion, the material of the mechanical part, and the surface treatment manner of the mechanical part; and
determining the preset volume of the sealant based on one or more of the volume of the sealing channel, the viscosity of the sealant, the curing manner of the sealant, the bubble discharge performance of the sealant under positive pressure extrusion, the material of the mechanical part, and the surface treatment manner of the mechanical part.

12. The mechanical part sealing method according to any one of claims 1 to 11, wherein a size of the first opening is greater than a size of the second opening.

13. The mechanical part sealing method according to any one of claims 1 to 12, wherein one of the first mechanical part and the second mechanical part is a display; and
the other of the first mechanical part and the second mechanical part is a middle frame of an electronic device, and the sealing channel is a gap between the display and the middle frame.

14. The mechanical part sealing method according to any one of claims 1 to 12, wherein one of the first mechanical part and the second mechanical part is a flexible circuit board; and
the other of the first mechanical part and the second mechanical part is a middle frame or an adapter of an electronic device, and the middle frame or the adapter of the electronic device is provided with a through hole for the flexible circuit board to pass through; and the sealing channel is a gap between the flexible circuit board and an inner wall of the through hole; or
the sealing channel is a gap between the middle frame or the adapter.

15. The mechanical part sealing method according to any one of claims 1 to 12, wherein one of the first mechanical part and the second mechanical part is a screw or a bolt;
the other of the first mechanical part and the second mechanical part is an adapter, and the adapter is provided with a threaded hole for the screw or the bolt to pass through; and
the sealing channel is a gap between the screw or the bolt and an inner wall of the threaded hole.

16. An electronic device, comprising a mechanical part, wherein the mechanical part comprises a first mechanical part and a second mechanical part, and there is a sealing channel between the first mechanical part and the second mechanical part; and
a sealant is disposed in the sealing channel, and the sealant seals the sealing channel by using the mechanical part sealing method according to any one of claims 1 to 15.

17. The electronic device according to claim 16, wherein one of the first mechanical part and the second mechanical part is a display of the electronic device;
the other of the first mechanical part and the second mechanical part is a middle frame of the electronic device; and
the sealing channel is a gap between the display and the middle frame.

18. The electronic device according to claim 17, wherein each of the display and the middle frame has an appearance surface; and
an opening at one end of the sealing channel extends to between the appearance surface of the display and the appearance surface of the middle frame, and an opening at the other end of the sealing channel faces an interior of the electronic device.

19. The electronic device according to claim 16, wherein one of the first mechanical part and the second mechanical part is a flexible circuit board of the electronic device; and
the other of the first mechanical part and the second mechanical part is a middle frame or an adapter of the electronic device, and the middle frame or the adapter of the electronic device is provided with a through hole for the flexible circuit board to pass through; and the sealing channel is a gap between the flexible circuit board and an inner wall of the through hole; or
the sealing channel is a gap between the middle frame or the adapter.

20. The electronic device according to claim 16, wherein one of the first mechanical part and the second mechanical part is a screw or a bolt of the electronic device;
the other of the first mechanical part and the second mechanical part is an adapter of the electronic device, and the adapter is provided with a threaded hole for the screw or the bolt to pass through; and
the sealing channel is a gap between the screw or the bolt and an inner wall of the threaded hole.

21. The electronic device according to any one of claims 16 to 20, wherein the sealing channel has a sealing end and a sealant injection end; and
a size of the sealant injection end is greater than a size of the sealing end, and the sealant injection end is located inside the electronic device.
